# EUROPEAN PATENT APPLICATION

(11) **EP 2 544 251 A2**
(43) Date of publication of application: **09.01.2013**
(21) Application number: 12153302.0
(22) Date of filing: 31.01.2012
(51) Int. Cl.: H01L 33/40, H01L 33/32, H01L 33/02

(54) **Nitride semiconductor light emitting device**

(30) Priority: 06.07.2011 KR 20110066925
(71) Applicant: Samsung Electronics Co., Ltd., Suwon-si, Gyeonggi-do, 443-742 (KR)
(72) Inventor: Shim, Hyun Wook, Gyeonggi-do (KR); Lee, Dong Ju, Gyeonggi-do (KR); Shin, Dong Ik, Gyeonggi-do (KR); Kim, Young Sun, Gyeonggi-do (KR); Asai, Makoto, Gyeonggi-do (KR); Sohn, Yu Ri, Seoul (KR)
(74) Representative: Grünecker, Kinkeldey, Stockmair & Schwanhäusser

(57) **Abstract**

Provided is a nitride semiconductor light emitting device (10) including: a light emitting structure having a p-type nitride semiconductor layer (16), an n-type nitride semiconductor layer (14), and an active layer (15) formed therebetween; p-side and n-side electrodes (19,18) respectively electrically connected to the p-type nitride semiconductor layer (16) and the n-type nitride semiconductor layer (14); and a contact layer (17) positioned between the p-type nitride semiconductor layer (16) and the p-side electrode (19), and including a first p-type nitride layer (17a) having a first impurity concentration to form ohmic contact with the p-side electrode (19) and a second p-type nitride layer (17b) having a second impurity concentration, the second impurity concentration having a concentration lower than the first impurity concentration.

## Description

### CROSS-REFERENCE TO RELATED APPLICATIONS

This application claims the priority of Korean Patent Application No. 10-2011-0066925 filed on July 6, 2011, in the Korean Intellectual Property Office, the disclosure of which is incorporated herein by reference.

### BACKGROUND OF THE INVENTION

### Field of the Invention

The present invention relates to a nitride semiconductor light emitting device, and more particularly, to a nitride semiconductor light emitting device having improved light emission efficiency and electrical reliability.

### Description of the Related Art

Recently, increasing interest has been shown in a nitride semiconductor light emitting device as a light source capable of covering a wide range of wavelengths, including wavelengths in the blue and green light bands, according to a composition rate thereof and a nitride semiconductor light emitting device has been widely used for a full color display, an image scanner, various signal systems and optical communications devices.

As such, research into, and development of, a nitride semiconductor light emitting device has increased to obtain improved light efficiency and reliability during a process of widely and practically using the nitride semiconductor light emitting device. As a means to this end, a scheme of lowering a threshold voltage Vf has been considered. Improved reliability and prolonged lifespan through a reduced amount of calorific value can be expected, while light efficiency may be improved by lowering a threshold voltage of a light emitting diode (LED).

In this scheme, a p-GaN layer may be doped with a high concentration (for example, 1×10^{20/}cm³ or more) p-type impurity, for example, Mg, so as to form an ohmic contact layer with the p-GaN contact layer having a high work function with regard to an electrode. Such a doped high impurity concentration may cause deterioration of crystal properties of the contact layer and light transmittance due to defects therefrom.

### SUMMARY OF THE INVENTION

An aspect of the present invention provides a nitride semiconductor light emitting device capable of providing ohmic contact with a p-side electrode while improving light transmittance through improved crystal properties.

According to an aspect of the present invention, there is provided a nitride semiconductor light emitting device including: a light emitting structure having a p-type nitride semiconductor layer, an n-type nitride semiconductor layer, and an active layer formed therebetween; p-side and n-side electrodes respectively electrically connected to the p-type nitride semiconductor layer and the n-type nitride semiconductor layer; and a contact layer positioned between the p-type nitride semiconductor layer and the p-side electrode, and including a first p-type nitride layer having a first impurity concentration to form ohmic contact with the p-side electrode and a second p-type nitride layer having a second impurity concentration, the second impurity concentration having a concentration lower than the first impurity concentration.

The first and second p-type nitride layers may each have a thickness ranging from 5 to 40nm. The second impurity concentration may be lower than that of an area contacting the contact layer among the p-type nitride semiconductor layers.

The first impurity concentration may be 10 or more times greater than that of the second impurity concentration. For example, the first impurity concentration of the first p-type nitride layer may be 1×10²⁰/cm³ or more, and the second impurity concentration of the second p-type nitride layer may be 5×10¹⁶ ∼1×10¹⁹/cm³.

As a detailed example, the contact layer may further include an additional first p-type nitride layer positioned between the second p-type nitride layer and the p-type nitride semiconductor layer.

Moreover, as another detailed example, the contact layer may further include at least one additional first p-type nitride layer and one additional second p-type nitride layer arrayed alternately between the second p-type nitride layer and the p-type nitride semiconductor layer. The additional first and second p-type nitride layers may have a thickness ranging from 5 to 40nm.

According to another aspect of the present invention, there is provided a nitride semiconductor light emitting device including: a light emitting structure including a p-type nitride semiconductor layer, an n-type nitride semiconductor layer, and an active layer formed therebetween; p-side and n-side electrodes respectively electrically connected to the p-type nitride semiconductor layer and the n-type nitride semiconductor layer; and a contact layer positioned between the p-type nitride semiconductor layer and the p-side electrode, and including a p-type nitride layer having a relatively high impurity concentration so as to form ohmic contact with the p-side electrode, and a current diffusion layer formed on the p-type nitride layer and the p-type nitride semiconductor layer and formed of at least one layer of n-type nitride and SiC layers.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a side cross-sectional view showing a nitride semiconductor light emitting device according to an embodiment of the present invention;
FIG. 2 is a side cross-sectional view showing a nitride semiconductor light emitting device according to a first varied example of an embodiment of the present invention;
FIG. 3 is a graph comparing light outputs of a nitride semiconductor light emitting device according to an example of the present invention and a comparative example;
FIG. 4 is a graph comparing ESD defect rates in a nitride semiconductor light emitting device according to an example of the present invention and a comparative example;
FIG. 5 is a side cross-sectional view showing a nitride semiconductor light emitting device according to a second varied example of the embodiment of the present invention; and
FIG. 6 is a side cross-sectional view of a nitride semiconductor light emitting device according to another embodiment of the present invention.

### DETAILED DESCRIPTION OF THE INVENTION

Embodiments of the present invention will now be described in detail with reference to the accompanying drawings such that they could be easily practiced by those having skill in the art to which the present invention pertains. However, in describing the embodiments of the present invention, detailed descriptions of well-known functions or constructions will be omitted so as not to obscure the description of the present invention with unnecessary detail.

In addition, like reference numerals denote like elements throughout the drawings.

Unless explicitly described to the contrary, the word "comprise" and variations such as "comprises" or "comprising," will be understood to imply the inclusion of stated elements but not the exclusion of other elements.

Hereinafter, embodiments of the present invention will be described in detail with reference to the accompanying drawings.

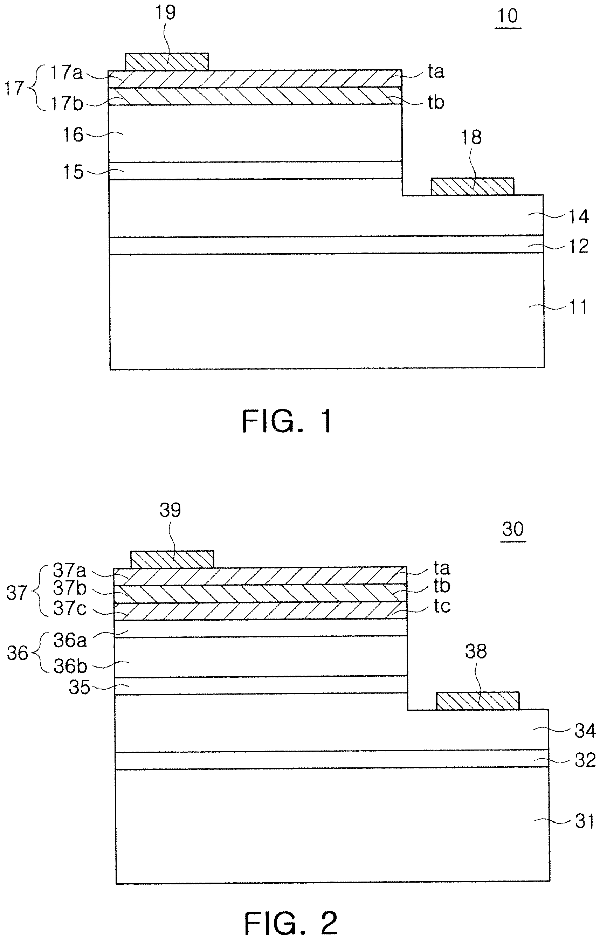

FIG. 1 is a side cross-sectional view showing a nitride semiconductor light emitting device according to an embodiment of the present invention.

A nitride semiconductor light emitting device 10 according to an embodiment of the present invention may include a light emitting structure including a p-type nitride semiconductor layer 16, an n-type nitride semiconductor layer 14 and an active layer 15 formed therebetween.

As shown in FIG. 1, in order to allow good quality crystal to be grown, a buffer layer 12 may be additionally formed on a nitride single-crystal growth substrate 11 such as a sapphire substrate.

The nitride semiconductor light emitting device 10 may include p-side and n-side electrodes 19 and 18, respectively connected to the p-type and the n-type nitride semiconductor layers 16 and 14. The p-type nitride semiconductor layer 16 and the p-side electrode 19 may have a contact layer 17 therebetween contacting the p-side electrode 19.

The contact layer 17 may include a first p-type nitride layer 17a and a second p-type nitride layer 17b having different impurity concentrations. For example, the first and second p-type nitride layers 17a and 17b may be a p-type GaN layer having different impurity concentrations.

The first p-type nitride layer 17a may be provided as a region directly contacting the p-side electrode 19. In general, among electrode materials, it is rare to provide a case having a high work function enough to form ohmic contact with a p-type nitride such as p-type GaN. Thus, at the time of band discrete occurrence, in order to form ohmic contact based on a carrier movement toward a level of impurity, a p-type impurity concentration may be determined to have a sufficiently high concentration.

An impurity concentration (hereinafter, referred to as 'first impurity concentration") for the above-mentioned ohmic contact may be a relatively high concentration, for example, 1×10²⁰/cm³ or more.

However, a high impurity concentration may badly affect crystal properties in a thin film as described above. That is, a p-type impurity concentration for ohmic contact may lower a level of light transmittance due to a lot of defects therefrom as well as greatly degraded crystal properties.

In order to eliminate the above-mentioned defects, as shown in FIG. 1, the contact layer 17 may include the second p-type nitride layer 17b having a second impurity concentration having an impurity concentration lower than that of the first impurity concentration, on a lower part of the first p-type nitride layer 17a that has the first impurity concentration sufficient to form ohmic contact with the p-side electrode 19. In addition, the second p-type nitride layer 17b may have a concentration lower than that of a region contacting the contact layer 17 among the p-type nitride semiconductor layer 16.

Since the second p-type nitride layer 17b is a thin film having a relatively low impurity concentration, brightness may be enhanced by improving light transmittance while providing relatively high crystal properties. Further, since the second p-type nitride layer 17b has an electrical resistance higher than that of the first p-type nitride layer 17a, a current diffusion characteristic may be improved, and therefore, the device may be effectively protected from a surge and an electrostatic discharge (ESD) impact.

Such first and second p-type nitride layers 17a and 17b may have respective thicknesses ta and tb ranging from 5 to 40nm. The first impurity concentration of the first p-type nitride layer 17a may have a 10-time concentration of the second impurity concentration of the second p-type nitride layer 17b, but is not limited thereto. For example, the first impurity concentration may be 1×10²⁰/cm³ or more, and the second impurity concentration may be 5×10¹⁶ ∼1×10¹⁹/cm³.

Although the contact layer employed according to the embodiment of the present invention is provided in a form of including one high concentration p-type nitride layer and one low concentration p-type nitride layer by way of a sample, unlike this case, the contact layer may be implemented in a manner of including a low concentration p-type nitride layer interposed between two high concentration p-type nitride layers or in an ultra-lattice structure form in which a plurality of respective high concentration p-type nitride layers and low concentration p-type nitride layers are included therein and alternately stacked.

As such, as the contact layer is implemented by inserting at least one low concentration p-type nitride layer, crystal properties may be improved, in a manner similar to that of the foregoing embodiment to thus increase light transmittance and further improve a current diffusion function, whereby reliability of the device may be greatly increased.

FIG. 2 is a side cross-sectional view of a nitride semiconductor light emitting device having a contact layer provided in a form in which a relatively low concentration nitride layer is inserted into relatively high concentration nitride layers according to another embodiment of the present invention.

A nitride semiconductor light emitting device 30 according to the embodiment of the present invention may include a light emitting structure that includes a p-type nitride semiconductor layer 36, an n-type nitride semiconductor layer 34 and an active layer 35 formed therebetween.

As shown in FIG. 2, in order to obtain high quality crystal to be grown on a nitride single-crystal growth substrate 31 such as a sapphire substrate, a buffer layer 32 may be formed. The nitride semiconductor light emitting device 30 may include p-side and n-side electrodes 39 and 38 respectively connected to the p-type and the n-type nitride semiconductor layers 36 and 34.

The p-type nitride semiconductor layer 36 may include a p-type GaN layer 36a and an AlGaN layer 36b, serving as an electron barrier layer (EBL), and may further include a contact layer 37 being in contact with the p-side electrode 39.

The contact layer 37 may include a first p-type nitride layer 37a and a second p-type nitride layer 37b having different impurity concentrations, similarly to the foregoing embodiment of the present invention, and may include an additional first p-type nitride layer 37a' between the p-type GaN layer 36a and the second p-type nitride layer 37b.

The first p-type nitride layer 37a contacting the p-side electrode 39 may have a first impurity concentration for forming the above-mentioned ohmic contact, and on a lower part thereof, the second p-type nitride layer 37b having a second impurity concentration, lower than the first impurity concentration, may be provided. The second p-type nitride layer 37b may be formed of a relatively low impurity concentration of a thin film.

In addition, the additional first p-type nitride layer 37a' may have an impurity concentration higher than a concentration of the second p-type nitride layer 37b similarly to the case of the first p-type nitride layer 37a, and may have substantially the same impurity concentration as that of the first p-type nitride layer 37a.

As described above, in the case of the contact layer 37 according to the embodiment of the present invention, it may be understood that it has a structure in which a low impurity concentration nitride layer 37b for improving crystal properties is inserted into high impurity concentration nitride layers 37a and 37a' for providing ohmic contact.

The first p-type nitride layer 37a and the second p-type nitride layer 37b may each have a thickness ranging from 5nm to 40nm. The impurity concentration of the first p-type nitride layer 37a may be 10 or more times greater than that of the impurity concentration of the second p-type nitride layer 37b. The impurity concentration of the additional first p-type nitride layer 37a' may be higher than that of the second p-type nitride layer 37b, and in a specific example, may be similar to that of the first p-type nitride layer 37a.

In a detailed example, the first p-type nitride layer 37a and the additional first p-type nitride layer 37a' may each have an impurity concentration of 1×10²⁰/cm³ or more, and in particular, may have substantially the same impurity concentration. In addition, the second p-type nitride layer 37b may have an impurity concentration of 5×10¹⁶ ∼1×10¹⁹/cm³.

Hereinafter, operation and effects according to a detailed embodiment of the invention will be described in detail.

### (Embodiment)

A first n-type GaN layer having an impurity concentration of 3×10¹⁹/cm³ and a second n-type GaN layer having an impurity concentration of 5×10²⁰/cm³ were formed on a sapphire substrate by using metal organic chemical vapor deposition (MOCVD) equipment, and an active layer including six pairs of In_{0.2}Ga_{0.8}N quantum well layers and GaN quantum barrier layers was formed thereon. Subsequently, a p-type Al_{0.2}Ga_{0.8}N electron blocking layer (EBL), which is a p-type nitride layer, and a p-type GaN layer having an impurity concentration of 1×10²⁰/cm³ were formed thereon.

Thereafter, a contact layer was formed such that a low concentration second p-type nitride layer was positioned between two high concentration first p-type nitride layers according to an embodiment of the present invention, in particular, a structure shown in FIG. 2. The first p-type nitride layer was formed to have a thickness of about 20nm and an impurity concentration of 5×10²⁰/cm³, and the second p-type nitride layer was formed to have a thickness of about 30nm and an impurity concentration of 5×10¹⁸/cm³.

### (Comparative Example)

A nitride semiconductor light emitting device was manufactured under the same conditions as the condition according to the foregoing embodiment of the present invention, but only with regard to a contact layer structure, a single high concentration p-type nitride layer was formed. That is, a contact layer according to the present comparative example was formed to have a thickness of about 80nm and an impurity concentration of 5×10²⁰/cm³.

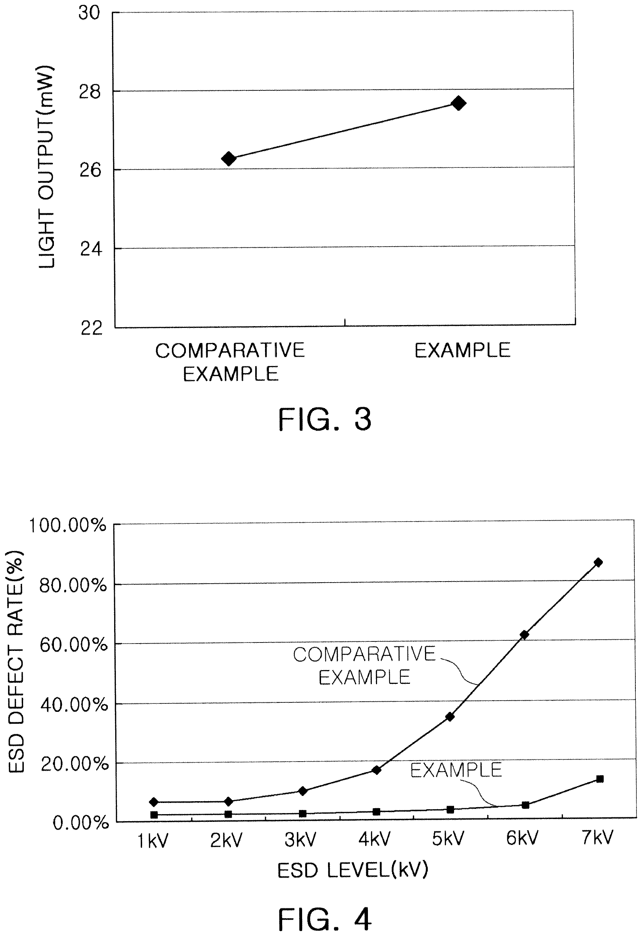

As described above, an ESD defect rate was investigated together with a light output with respect to the nitride semiconductor light emitting devices obtained according to the above-mentioned Embodiment and Comparative Example, and results thereof were shown in the graphs of FIGS. 3 and 4.

First, referring to FIG. 3, in the case of the nitride semiconductor light emitting device manufactured according to an Example of the present inveniton, a light output has been improved about 5%, from 26.2mW to 27.6mW, as compared to the nitride semiconductor light emitting device according to the Comparative Example.

In the Comparative Example, crystal properties in the contact layer were deteriorated due to the high impurity concentration and a light transmittance was relatively reduced, while in the contact layer according to the Example, crystal properties in the contact layer were improved by introducing a second p-type nitride layer capable of securing a relatively low impurity concentration and high quality crystal, whereby light transmittance has been improved.

In addition, current diffusion effects can be expected through the introduction of the second p-type nitride layer having electrical resistance lower than that of the first p-type nitride layer, and as shown in FIG. 4, it could be also confirmed that a rate of defectivity, due to ESD, has been significantly improved. In particular, the improvement was considerably exhibited in a high ESD level of 5KV.

As such, an area contacting a p-side electrode may secure a relatively high impurity concentration to thus form ohmic contact, and simultaneously therewith, may improve brightness by introducing a low concentration nitride layer to prevent light transmittance from being degraded due to defects in crystal. Further, the device may be effectively protected from power surges and ESD impact by improving a current diffusion characteristic thereof.

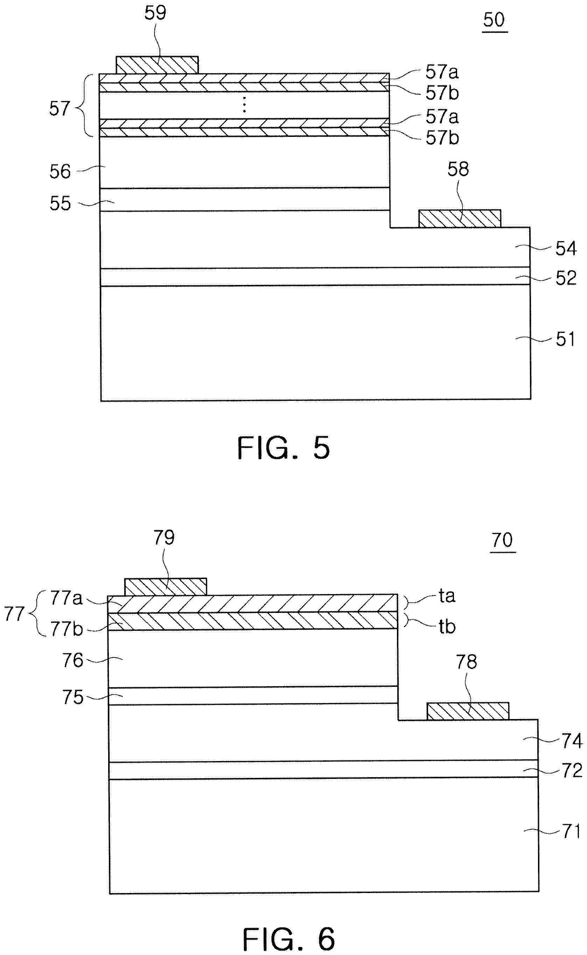

In the embodiment of the present invention, two layers having different levels of electrical conductivity due to different concentrations of impurities may be alternately laminated, whereby device reliability may be further enhanced while significantly improving current diffusion characteristics thereof. This variation example is illustrated in FIG. 5.

A nitride semiconductor light emitting device 50 shown in FIG. 5 may include a light emitting structure including a p-type nitride semiconductor layer 56, an n-type nitride semiconductor layer 54 and an active layer 55 formed therebetween.

As illustrated in FIG. 5, a buffer layer 52 may be formed on a nitride single-crystal growth substrate 51 such as a sapphire substrate. The nitride semiconductor light emitting device 50 may include p-side and n-side electrodes 59 and 58 respectively connected to the p-type and the n-type nitride semiconductor layers 56 and 54.

The p-type nitride semiconductor layer 56 may include a contact layer 57 formed thereon, the contact layer 57 contacting the p-side electrode 59. The contact layer 57 may include a first p-type nitride layer 57a and a second p-type nitride layer 57b having a different impurity concentration, similarly to those in the foregoing embodiment, but in the present embodiment, a plurality of respective first and second p-type nitride layers are employed to have a structure in which they are alternately stacked.

The first and second p-type nitride layers employed in the present embodiment could be understood with reference to the respective first and second p-type nitride layers described in FIGS. 1 and 2.

In the present embodiment, an area contacting the p-side electrode may secure a relatively high impurity concentration such that a light transmittance may be prevented from being deteriorated while forming ohmic contact by improving crystal properties, and further, more enhanced reliability effects (strengthening an ESD characteristic) of the device may be expected as compared to effects to be expected according to the foregoing embodiment.

According to another embodiment of the present invention, a scheme in which a portion in elements configuring the contact layer, an element corresponding to a low concentration layer, is substituted with a different single-crystal layer instead of a p-type nitride layer, may be provided. The substituted single-crystal layer may be a single crystal capable of securing a relatively high level of light transmittance by providing excellent crystal properties, rather than a high concentration p-type nitride layer providing a contact area while providing current diffusion effects by inducing relatively high electrical resistance.

A nitride semiconductor light emitting device 70 shown in FIG. 6 may include p-side and n-side electrodes 79 and 78 respectively contacting the p-type and the n-type nitride semiconductor layers 76 and 74. The p-type nitride semiconductor layer 76 may include a contact layer 77 contacting the p-side electrode 79.

In the present embodiment, the contact layer 77 may include a p-type nitride layer 77a directly contacting the p-side electrode 79 and a current diffusion layer 77b positioned between the p-type nitride layer 77a and the p-type nitride semiconductor layer 76.

The p-type nitride layer 77a may be determined to have a sufficiently high concentration of p-type impurities in order to form ohmic contact, and the concentration thereof may be 1×10²⁰/cm³ or more as mentioned above.

The current diffusion layer 77b according to the present embodiment may be a single-crystal layer, a partial element configuring the contact layer 77, which has electrical resistance higher than that of the p-type nitride layer 77a but has relatively excellent crystal properties to thus have relatively high light transmittance. The current diffusion layer 77b may be at least one of a SiC layer and an n-type nitride layer. That is, the SiC layer and the n-type nitride layer may be provided as a single, but a double-layer form in which two layers are combined may be provided.

In a case in which as the current diffusion layer 77b, an n-type nitride layer is introduced, crystal properties thereof may be maintained even when a relatively high concentration as compared to that of p-type impurities is allowed. For example, the impurity concentration of the n-type nitride layer may be within the range of 5×10¹⁶ ∼5×10¹⁹/cm³.

Meanwhile, as the current diffusion layer 77b, a SiC single-crystal layer may be used. In this case, since the layer may have a lattice constant similar to the same crystal structure, the layer may be provided to have excellent crystal properties and improved electrical reliability based on an electrical characteristic different from that of a nitride layer. The p-type nitride layer 77a and the current diffusion layer 77b may have respective thicknesses ta and tb ranging from 20nm to 40nm.

The contact layer employed according to the present embodiment may be provided to have one p-type nitride layer of a high concentration and one current diffusion layer by way of an example, but unlike this case, may be implemented in a form in which a current diffusion layer is interposed between two high concentration p-type nitride layers or may be implemented to have an ultra-lattice structure in which a plurality of respective p-type nitride layers having a high concentration and current diffusion layers are alternately stacked by including the plurality of respective high concentration p-type nitride layers and current diffusion layers, as shown in the structure of FIG. 2.

In this embodiment, light transmittance may be also increased by improving relatively low crystal properties caused in existing contact layer only formed of a high concentration nitride layer, and in addition, the reliability of the device may be enhanced through improved current diffusion function.

As set forth above, according to an embodiment of the invention, contact layer crystal properties may be improved by inserting at least one low concentration doped p-type nitride layer into a high concentration doped contact layer, thereby improving a reduced level of light transmittance due to defects therefrom. In addition, current diffusion characteristics may be improved due to relatively low electrical conductivity in the low concentration doped nitride layer, and electrical characteristics of a device and device reliability may be enhanced through relieved power surge and ESD impact.

While the present invention has been shown and described in connection with the embodiments in the embodiments, it will be apparent to those skilled in the art that modifications and variations can be made without departing from the spirit and scope of the invention as defined by the appended claims.

## Claims

1. A nitride semiconductor light emitting device comprising:
a light emitting structure having a p-type nitride semiconductor layer, an n-type nitride semiconductor layer, and an active layer formed therebetween;
p-side and n-side electrodes respectively electrically connected to the p-type nitride semiconductor layer and the n-type nitride semiconductor layer; and
a contact layer positioned between the p-type nitride semiconductor layer and the p-side electrode, and including a first p-type nitride layer having a first impurity concentration to form ohmic contact with the p-side electrode and a second p-type nitride layer having a second impurity concentration, the second impurity concentration having a concentration lower than the first impurity concentration.

2. The device of claim 1, wherein the first and second p-type nitride layers have a thickness ranging from 5 to 40nm.

3. The device of claim 1 or 2, wherein the second impurity concentration is lower than that of an area contacting the contact layer among the p-type nitride semiconductor layers.

4. The device of any one of claims 1 to 3, wherein the first impurity concentration is 10 or more times greater than that of the second impurity concentration.

5. The device of any one of claims 1 to 4, wherein the first impurity concentration of the first p-type nitride layer is 1×10²⁰/cm³ or more, and the second impurity concentration of the second p-type nitride layer is 5×10¹⁶ ∼1×10¹⁹/cm³.

6. The device of any one of claims 1 to 5, wherein the contact layer further includes an additional first p-type nitride layer positioned between the second p-type nitride layer and the p-type nitride semiconductor layer.

7. The device of any one of claims 1 to 5, wherein the contact layer further includes at least one additional first p-type nitride layer and one additional second p-type nitride layer arrayed alternately between the second p-type nitride layer and the p-type nitride semiconductor layer.

8. The device of claims 6 or 7, wherein the additional first and second p-type nitride layers have a thickness ranging from 5 to 40nm.

9. A nitride semiconductor light emitting device comprising:
a light emitting structure including a p-type nitride semiconductor layer, an n-type nitride semiconductor layer, and an active layer formed therebetween;
p-side and n-side electrodes respectively electrically connected to the p-type nitride semiconductor layer and the n-type nitride semiconductor layer; and
a contact layer positioned between the p-type nitride semiconductor layer and the p-side electrode, and including a p-type nitride layer having a relatively high impurity concentration so as to form ohmic contact with the p-side electrode, and a current diffusion layer formed on the p-type nitride layer and the p-type nitride semiconductor layer and formed of at least one layer of n-type nitride and Sic layers.

10. The device of claim 9, wherein the p-type nitride layer and the current diffusion layer each have a thickness ranging from 5 to 40nm.

11. The device of claim 9 or 10, wherein the p-type nitride layer has an impurity concentration of 1×10²⁰/cm³ or more, the current diffusion layer is formed of an n-type nitride, and the n-type nitride has a concentration of 5×10¹⁶∼5×10¹⁹/cm³.

12. The device of any one of claims 9 to 11, wherein the contact layer further includes an additional p-type nitride layer positioned between the current diffusion layer and the p-type nitride semiconductor layer.

13. The device of any one of claims 9 to 11, wherein the contact layer further includes at least one additional p-type nitride layer and one additional current diffusion layer arrayed alternately between the p-type nitride layer and the p-type nitride semiconductor layer.

14. The device of claim 12 or 13, wherein the additional p-type nitride layer and current diffusion layer each have a thickness ranging from 5 to 40nm.
